# EUROPEAN PATENT APPLICATION

(11) **EP 4 822 439 A1**
(43) Date of publication of application: **14.10.2026**
(21) Application number: 24903317.6
(22) Date of filing: 15.10.2024
(51) Int. Cl.: G03F 7/20, H05G 2/00

(54) **PLASMA GENERATION MECHANISM AND LIGHT SOURCE DEVICE**

(30) Priority: 12.12.2023 JP 2023209296
(71) Applicant: Ushio Denki Kabushiki Kaisha, Minato-ku, Tokyo 1080073 (JP)
(72) Inventor: ASHIZAWA, Noritaka, Tokyo 1080073 (JP); YAJIMA, Daisuke, Tokyo 1080073 (JP); GOTO, Naoki, Tokyo 1080073 (JP)
(74) Representative: Maiwald GmbH
(86) International application number: PCT/JP2024/036632
(87) International publication number: WO 2025/126654

(57) **Abstract**

To provide a plasma generation mechanism and a light source apparatus that are capable of preventing malfunctions caused by debris generated along with plasma generation.

A plasma generation mechanism according to an embodiment of the present invention is a plasma generation mechanism included in a light source apparatus that converts a liquid plasma raw material into plasma by irradiation of an energy beam and extracts radiation, the plasma generation mechanism including a rotation body, a rotational drive source, a raw material supply section, and a debris reflecting surface. The rotation body has a rotation surface, the rotation surface being a surface that rotates about a rotation axis. The rotational drive source rotates the rotation body about the rotation axis. The raw material supply section supplies the plasma raw material to the rotation body. The debris reflecting surface faces in a direction normal to an irradiation position that is irradiated with the energy beam, and reflects debris incident from the irradiation position in a direction different from an incident path of the energy beam to the irradiation position.

## Description

### Technical Field

The present invention relates to a plasma generation mechanism and a light source apparatus that supply a plasma raw material to an energy beam irradiation position to generate plasma.

### Background Art

X-rays have been conventionally used for medical, industrial, and research applications. In the medical field, X-rays are used for such applications as chest radiography, dental radiography, and computed tomography (CT). In the industrial field, X-rays are used for such applications as non-destructive testing and tomographic non-destructive testing to observe the inside of materials such as structures and welds. In the research field, X-rays are used for such applications as X-ray diffraction to analyze the crystal structure of materials and X-ray spectroscopy (X-ray fluorescence analysis) to analyze the constituent elements of materials. Extreme ultraviolet light (hereinafter, also referred to as "EUV light") having a wavelength of 13.5 nm, which is in the soft X-ray region having a relatively long wavelength among X-rays, has been recently used for exposure light.

Some EUV light source apparatuses that generate EUV light generate high-temperature plasma by applying an energy beam to a plasma raw material such as molten tin or lithium to excite the plasma raw material and extract EUV light from the high-temperature plasma. A method of using a laser beam as an energy beam is called laser produced plasm (LPP), and a method of using discharge is called discharge produced plasma (DPP) or laser assisted discharge produced plasma (LDP).

Known LPP-type EUV light source apparatuses generate plasma by collecting a laser beam on liquid droplets of a plasma raw material to excite the raw material. Meanwhile, in recent years, a method of supplying a plasma raw material to a laser beam irradiation region using the centrifugal force of a rotation body has been developed (see, for example, Patent Literature 1). In this method, the rotation body rotates while the lower part thereof is immersed in the stored plasma raw material, thereby causing the plasma raw material to adhere to the rotation body surface and supplying the plasma raw material to the irradiation region on the rotation body surface. Since this method does not need to supply a plasma raw material in the form of liquid droplets, it is possible to obtain high-intensity radiation with a relatively simple configuration as compared with a method of collecting a laser beam on liquid droplets.

### Citation List

### Patent Literature

Patent Literature 1: Japanese Patent Application Laid-open No. 2014-216286

### Disclosure of Invention

### Technical Problem

However, when a laser beam is applied to the plasma raw material, debris, which is vapor and fumes of the plasma raw material, is generated together with plasma. When a laser beam is applied to the rotation body surface to which the plasma raw material has been applied as described in Patent Literature 1, a large amount of debris belches out in the direction normal to the rotation body surface. Even with a configuration in which the rotation body is surrounded by a cover and debris is sealed by the cover, the cover needs an opening through which a laser beam or EUV light passes.

When debris is released from this opening, there is a risk of causing malfunctions, such as debris adhering to external members and causing unwanted electrical conduction. In addition, if debris adheres to the opening, the debris may narrow the opening, and the laser beam or EUV light passing through the opening may be blocked or attenuated, resulting in a decrease in output of EUV light. Further, if debris floats near the opening, the EUV light may be absorbed by the debris, resulting in a decrease in output of the EUV light.

In view of the circumstances as described above, it is an object of the present invention to provide a plasma generation mechanism and a light source apparatus that are capable of preventing malfunctions caused by debris generated along with plasma generation.

### Solution to Problem

In order to achieve the above-mentioned object, a plasma generation mechanism according to an embodiment of the present invention is a plasma generation mechanism included in a light source apparatus that converts a liquid plasma raw material into plasma by irradiation of an energy beam and extracts radiation, the plasma generation mechanism including a rotation body, a rotational drive source, a raw material supply section, and a debris reflecting surface.

The rotation body has a rotation surface, the rotation surface being a surface that rotates about a rotation axis.

The rotational drive source rotates the rotation body about the rotation axis.

The raw material supply section supplies the plasma raw material to the rotation body.

The debris reflecting surface faces in a direction normal to an irradiation position that is irradiated with the energy beam, and reflects debris incident from the irradiation position in a direction different from an incident path of the energy beam to the irradiation position.

According to this configuration, when the energy beam is incident at the irradiation position and debris is generated at the irradiation position, the debris is incident on the debris reflecting surface facing in the direction normal to the irradiation position and is reflected in a direction different from the incident path of the energy beam. This suppresses the influences on the energy beam due to the debris and prevents a decrease in output of radiation or the like.

The irradiation position may be located on the rotation surface.

The debris reflecting surface may reflect the debris incident from the irradiation position in a direction different from the incident path of the energy beam to the irradiation position and an emission path of the radiation from the irradiation position.

The raw material supply section may include a reservoir that stores the plasma raw material, and part of the rotation surface of the rotation body may be immersed in the plasma raw material stored in the reservoir.

The plasma generation mechanism may further include a cover that forms the reservoir and surrounds the rotation body, and a direction normal to the debris reflecting surface at each position of the debris reflecting surface may face inside the cover.

The cover may include an opening through which the energy beam passes, and the debris reflecting surface may reflect the debris incident from the irradiation position in a direction different from the opening.

The opening may include an incident port through which the energy beam passes, and an emission port through which the radiation passes, and the debris reflecting surface may face the irradiation position via the opening.

The cover may include a facing surface that faces the rotation surface, and the debris reflecting surface may be a surface of a debris reflecting structure provided on the facing surface at a position facing the irradiation position.

The debris reflecting surface may be a surface of a debris reflecting structure supported by a support member different from the cover.

The debris reflecting surface may be at least partially curved.

The debris reflecting surface may be a surface of a rotatable debris reflecting structure.

The radiation may be extreme ultraviolet light or X-rays.

The plasma raw material may be tin, lithium, gadolinium, terbium, gallium, bismuth, indium, or an alloy including at least one of these materials.

In order to achieve the above-mentioned object, a light source apparatus according to an embodiment of the present invention is a light source apparatus that converts a liquid plasma raw material into plasma by irradiation of an energy beam and extracts radiation, the light source apparatus including a plasma generation mechanism and a beam source.

The plasma generation mechanism includes a rotation body having a rotation surface, the rotation surface being a surface that rotates about a rotation axis, a rotational drive source that rotates the rotation body about the rotation axis, a raw material supply section that supplies the plasma raw material to the rotation body, and a debris reflecting surface that faces in a direction normal to an irradiation position that is irradiated with the energy beam, and reflects debris incident from the irradiation position in a direction different from an incident path of the energy beam to the irradiation position.

The beam source causes the energy beam to be incident at the irradiation position.

### Advantageous Effects of Invention

According to the present invention, it is possible to provide a plasma generation mechanism and a light source apparatus that are capable of preventing malfunctions caused by debris generated along with plasma generation.

### Brief Description of Drawings

[Fig. 1] Fig. 1 is a schematic view of a light source apparatus according to an embodiment of the present invention.
[Fig. 2] Fig. 2 is a schematic view of a plasma generation mechanism included in the light source apparatus.
[Fig. 3] Fig. 3 is a perspective view of a rotation body unit included in the plasma generation mechanism.
[Fig. 4] Fig. 4 is a schematic view showing an operation of the light source apparatus.
[Fig. 5] Fig. 5 is a schematic view showing an operation of a light source apparatus without a debris reflecting structure.
[Fig. 6] Fig. 6 is a schematic diagram showing an incident angle and a reflection angle of debris incident on a debris reflecting surface of the debris reflecting structure.
[Fig. 7] Fig. 7 is a graph of simulation results (collision angle of 45°).
[Fig. 8] Fig. 8 is a graph of simulation results (collision angle of 60°).
[Fig. 9] Fig. 9 is a graph plotting an average recoil angle against a collision angle in the simulation results.
[Fig. 10] Fig. 10 is a perspective view of a debris reflecting structure having another configuration.
[Fig. 11] Fig. 11 is a schematic view showing reflection of debris on the debris reflecting surface.
[Fig. 12] Fig. 12 is a schematic view showing a direction normal to a debris reflecting surface of a debris reflecting structure having another configuration.
[Fig. 13] Fig. 13 is a perspective view of a debris reflecting structure having another support configuration.
[Fig. 14] Fig. 14 is a cross-sectional view of a rotation body unit including a debris reflecting structure configured to be rotatable.
[Fig. 15] Fig. 15 is a cross-sectional view of a rotation body unit including a rotary foil trap. Mode(s) for Carrying Out the Invention

A light source apparatus according to an embodiment of the present invention will be described.

### [Basic Configuration of Light Source Apparatus]

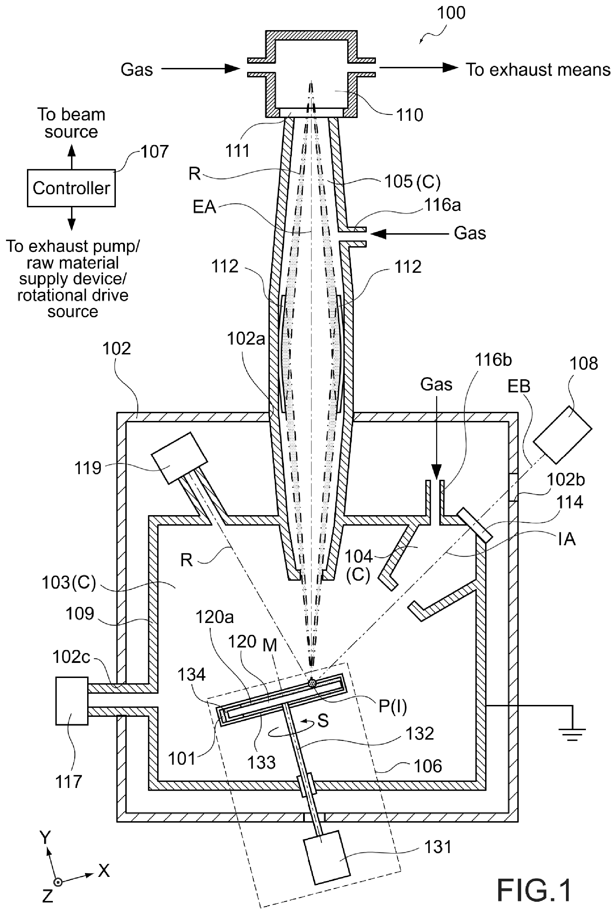

Fig. 1 is a schematic view showing a configuration example of a light source apparatus 100 according to this embodiment. The light source apparatus 100 is a laser produced plasma (LPP)-based light source apparatus. In other words, the light source apparatus 100 is an apparatus that generates plasma P by applying an energy beam EB to a plasma raw material 101 to excite the plasma raw material 101 as shown in Fig. 1, extracts radiation R released from plasma P, and uses the radiation R as a light source. The radiation R is extreme ultraviolet (EUV) light, X-rays, or other electromagnetic waves.

The plasma raw material 101 is tin (Sn), lithium (Li), gadolinium (Gd), terbium (Tb), gallium (Ga), bismuth (Bi), indium (In), or an alloy including at least one of those materials and is liquid. In the case where EUV light is emitted as the radiation R, molten Sn or Li is used as the plasma raw material 101. In the case where X-rays are emitted as the radiation R, molten Ga, Ga alloy, Sn compound, or the like is used as the plasma raw material 101.

Fig. 1 illustrates a schematic cross section of the light source apparatus 100 when the light source apparatus 100 is cut along the horizontal direction at a predetermined height from its installation surface and viewed from vertically above. In Fig. 1, the illustration of the cross section is omitted for portions for which the configuration of the cross section does not need to be explained, in order to facilitate the understanding of the configuration and operation of the light source apparatus 100. In the following description, the X direction refers to the right-and-left direction (the positive side of the X axis is the right side, and the negative side is the left side) of the horizontal direction, the Y direction refers to the front-and-rear direction (the positive side of the Y axis is the front side, and the negative side is the rear side) of the horizontal direction, and the Z direction refers to the vertical direction (the positive side of the Z axis is the upper side, and the negative side is the lower side). Obviously, regarding the application of the present technology, the orientation in which the light source apparatus 100 is used, and the like are not limited.

As shown in Fig. 1, the light source apparatus 100 includes an enclosure 102, a vacuum chamber 103, an energy beam incident chamber 104, a radiation emission chamber 105, a plasma generation mechanism 106, a controller 107, and a beam source 108.

In the example shown in Fig. 1, the enclosure 102 includes an emission hole 102a, an incident hole 102b, and a through-hole 102c. In this embodiment, an emission axis EA of the radiation R is set such that it passes through the emission hole 102a. The radiation R is extracted along the emission axis EA and released through the emission hole 102a. Further, in this embodiment, an incident axis IA of the energy beam EB is set such that it passes through the incident hole 102b.

As shown in Fig. 1, the beam source 108 that emits the energy beam EB is disposed outside the enclosure 102. The beam source 108 is disposed to allow the energy beam EB to enter the inside of the enclosure 102 along the incident axis IA. Examples of the energy beam EB include an electron beam and a laser beam.

The light source apparatus 100 is provided with a chamber section C that includes a plurality of chambers. Specifically, the chamber section C includes the vacuum chamber 103, the energy beam incident chamber (hereinafter, referred to simply as the "incident chamber") 104, and the radiation emission chamber (hereinafter, referred to simply as the "emission chamber") 105. The vacuum chamber 103 and the incident chamber 104 are connected to each other, and the vacuum chamber 103 and the emission chamber 105 are connected to each other.

The incident chamber 104 is formed to be located on the incident axis IA of the energy beam EB, and the emission chamber 105 is formed to be located on the emission axis EA of the radiation R.

A collector (focusing mirror) 112 for guiding the radiation R is disposed inside the emission chamber 105. Further, the vacuum chamber 103 is provided with the plasma generation mechanism 106 that generates the plasma P.

A utilization device such as a mask inspection device is connected to the end portion of the emission chamber 105 on the opposite side of the plasma generation mechanism 106. In the example shown in Fig. 1, an application chamber 110 is connected as a chamber constituting part of the utilization device. The pressure inside the application chamber 110 may be an atmospheric pressure. In addition, the inside of the application chamber 110 may be purged with gas (e.g., inert gas) from a gas injection channel as necessary. Additionally, the gas inside the application chamber 110 may be exhausted by an exhaust means, which is not shown in the figure. A filter film 111 for physically separating a region where the plasma P is generated and the application chamber 110 from each other is provided between the application chamber 110 and the emission chamber 105.

An incident window 114 is provided in a chamber body 109. The incident window 114 is disposed along the incident axis IA of the energy beam EB and in line with the incident hole 102b. In addition, an exhaust pump 117 is connected to the chamber body 109.

Additionally, as shown in Fig. 1, gas injection channels 116a and 116b are respectively provided in the emission chamber 105 and the incident chamber 104, and gas is supplied to the emission chamber 105 and the incident chamber 104 from a gas supply device, which is omitted in the figure. A gas having high transmittance to the radiation R, such as argon or helium, is supplied to the emission chamber 105. Alternatively, a gas having high transmittance to the energy beam EB, such as argon or helium, is supplied to the incident chamber 104.

The plasma generation mechanism 106 is a mechanism for generating the plasma P inside the vacuum chamber 103 and releasing the radiation R (X-rays, EUV light). As shown in Fig. 1, the plasma generation mechanism 106 includes a rotation body 120, and the energy beam EB is incident on the rotation body 120. The rotation body 120 is disposed inside the vacuum chamber 103 such that an irradiation position I of the energy beam EB is placed at the intersection between the incident axis IA and the emission axis EA. Details of the plasma generation mechanism 106 will be described later.

The controller 107 controls the operation of each constituent element provided in the light source apparatus 100. For example, the controller 107 controls the operation of the beam source 108 and the exhaust pump 117. The controller 107 includes hardware circuits necessary for a computer, such as CPUs and memories (RAM, ROM). A CPU loads a control program stored in a memory into a RAM and executes it to perform various processes. As the controller 107, for example, a device such as a programmable logic device (PLD) may be used. In Fig. 1, the controller 107 is schematically illustrated as a function block. However, the controller 107 may be designed in any desired manner including the position at which the controller 107 is configured.

Moreover, as shown in Fig. 1, in this embodiment, a radiation diagnosis section 119 is connected to the chamber body 109. The radiation diagnosis section 119 is disposed at a position at which the radiation R radiated in a direction different from the emission axis EA of the radiation R is incident. The radiation diagnosis section 119 measures the state of the radiation R emitted from the plasma P.

### [Configuration of Plasma Generation Mechanism]

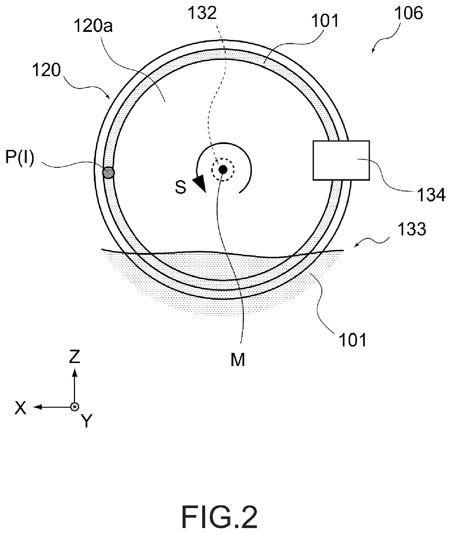

As described above, the plasma generation mechanism 106 is a mechanism for generating the plasma P inside the vacuum chamber 103 and releasing the radiation R (X-rays or EUV light). Fig. 2 is a schematic view of the plasma generation mechanism 106. As shown in Fig. 2, the plasma generation mechanism 106 includes the rotation body 120, a rotational drive source 131, a shaft portion 132, a reservoir 133, and a film thickness adjustment mechanism 134.

The rotational drive source 131 is disposed outside the vacuum chamber 103 and generates rotational power for the rotation body 120. The rotational drive source 131 is, for example, a motor. The shaft portion 132 penetrates the chamber body 109 and the enclosure 102 to connect the rotational drive source 131 and the rotation body 120, and transmits the rotational power generated in the rotational drive source 131 to the rotation body 120. The reservoir 133 is disposed vertically below the rotation body 120 and stores the plasma raw material 101.

The rotation body 120 is disposed inside the vacuum chamber 103 and connected to the shaft portion 132. The rotation body 120 rotates by the rotation of the shaft portion 132 as shown by the arrow S in Fig. 2. Hereinafter, the rotation axis of the rotation body 120 and the shaft portion 132 will be referred to as a rotation axis M.

As shown in Fig. 2, the rotation body 120 has a disc shape. Hereinafter, the surface of the rotation body 120 on the side opposite to the shaft portion 132 will be referred to as a rotation surface 120a. The rotation axis M is, for example, parallel to the horizontal direction (X-Y direction) and located such that the rotation surface 120a is parallel to the vertical direction. Part of the rotation surface 120a is immersed in the plasma raw material 101 stored in the reservoir 133, and the plasma raw material 101 adheres to the rotation surface 120a as it rotates. The plasma raw material 101 that has adhered to the rotation surface 120a is transported to the irradiation position I as the rotation body 120 rotates, and converted into plasma by the energy beam EB applied to the irradiation position I.

As shown in Fig. 2, the film thickness adjustment mechanism 134 is disposed on the rotation body 120 and adjusts the film thickness of the plasma raw material 101 that has adhered to the rotation surface 120a. The film thickness adjustment mechanism 134 is, for example, a structure having a channel structure, disposed so as to sandwich the rotation body 120 thereinside with a predetermined gap therebetween, and adjusts the film thickness of the plasma raw material 101 by scraping off the plasma raw material 101 that has not flowed into the gap. The film thickness adjustment mechanism 134 is provided on the upstream side of the irradiation position I in the rotational direction of the rotation body 120 and determines the film thickness of the plasma raw material 101 at the irradiation position I.

In the plasma generation mechanism 106, as described above, the plasma raw material 101 stored in the reservoir 133 adheres to the rotation surface 120a of the rotation body 120 and is transported to the irradiation position I by the rotation of the rotation body 120. Therefore, the reservoir 133 functions as a "raw material supply section" that supplies the plasma raw material 101 to the rotation surface 120a.

### [Regarding Configuration of Rotation Body Unit]

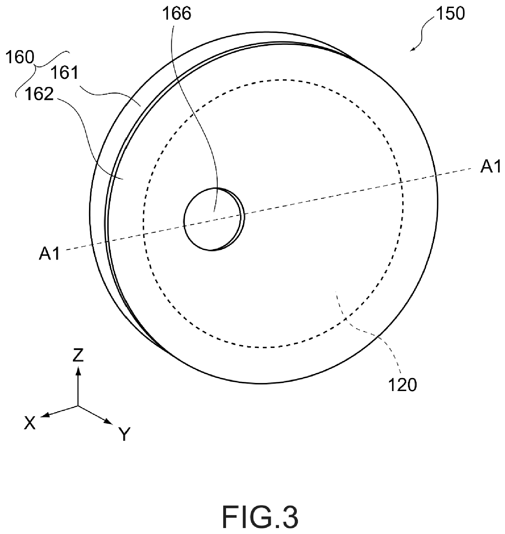

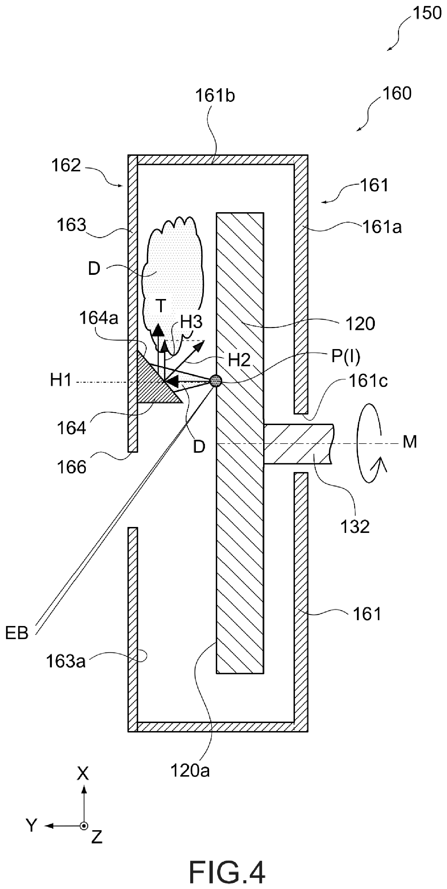

The plasma generation mechanism 106 includes a rotation body unit that houses the rotation body 120. Fig. 3 is a perspective view of a rotation body unit 150. As shown in the figure, the rotation body unit 150 includes the rotation body 120 and a cover 160, and the rotation body 120 is housed in the cover 160. Note that in Figs. 1 and 2, illustration of the cover 160 is omitted. Fig. 4 is a cross-sectional view of the rotation body unit 150 and is a cross-sectional view taken along the line A1-A1 (X-Y plane) in Fig. 3.

The cover 160 surrounds the rotation body 120 to prevent debris from scattering and forms the reservoir 133. The cover 160 includes a first cover member 161 and a second cover member 162. As shown in Fig. 3, the rotation body 120 is housed inside the cover 160.

In addition, the plasma raw material 101 is stored in the vertically lower portion of the cover 160, and the vertically lower portion of the cover 160 forms the reservoir 133. A heating mechanism (not shown) is provided to the periphery of the reservoir 133 and heats and melts the plasma raw material 101 stored in the reservoir 133.

As shown in Fig. 4, the first cover member 161 includes a bottom portion 161a and a side wall portion 161b. The bottom portion 161a has a disc shape and is provided with a through-hole 161c at the center thereof as shown in Fig. 4. The through-hole 161c is a hole through which the shaft portion 132 is inserted. The side wall portion 161b has a cylindrical shape and is continuous to the peripheral edge of the bottom portion 161a.

As shown in Fig. 4, the second cover member 162 is joined to the side wall portion 161b of the first cover member 161. As shown in the figure, the second cover member 162 includes a flat plate portion 163 and a debris reflecting structure 164. The flat plate portion 163 has a flat plate shape and faces the rotation surface 120a of the rotation body 120 as shown in Fig. 4. As shown in Fig. 4, the surface of the flat plate portion 163 facing the rotation surface 120a is referred to as a facing surface 163a. The facing surface 163a is a surface parallel to the rotation surface 120a, e.g., a surface parallel to the vertical direction.

As shown in Fig. 4, the flat plate portion 163 is provided with an opening 166. The opening 166 is an opening provided to penetrate the second cover member 162, through which the energy beam EB and the radiation R pass.

The debris reflecting structure 164 faces the irradiation position I and reflects debris generated along with plasma generation. As shown in Fig. 4, the debris reflecting structure 164 is provided on the facing surface 163a at a position facing the irradiation position I, specifically, provided to be adjacent to the opening 166.

The debris reflecting structure 164 has a debris reflecting surface 164a. The debris reflecting surface 164a is a surface of the debris reflecting structure 164 on the side close to the rotation body 120, and is a surface that reflects debris incident from the irradiation position I. The debris reflecting surface 164a faces in a direction H1 normal to the irradiation position I as shown in Fig. 4, and reflects the debris incident from the irradiation position I in a direction different from an incident path of the energy beam EB to the irradiation position I and an emission path of the radiation R from the irradiation position I. Specifically, the debris reflecting surface 164a reflects debris in a direction different from the opening 166.

The debris reflecting surface 164a is a surface, at least part of which is not perpendicular to the normal direction H1 and not parallel to the normal direction H1. As shown in Fig. 4, the direction normal to the debris reflecting surface 164a is referred to as a normal direction H2. As shown in the figure, the debris reflecting surface 164a is a flat surface inclined to the facing surface 163a, and is a surface on which the normal direction H2 at each position is parallel.

### [Operation and Effects of Light Source Apparatus]

The operation and effects of the light source apparatus 100 will be described. The energy beam EB converts the plasma raw material 101 into plasma at the irradiation position I to generate the plasma P as shown in Fig. 4. The radiation R (see Fig. 1) is released from the plasma P and emitted through the opening 166.

Along with this conversion into plasma, debris D, which is vapor and fumes of the plasma raw material 101, belches out from the irradiation position I as shown in Fig. 4. The debris D belches out mainly along a direction H1 normal to the rotation surface 120a (Y direction).

Here, in the rotation body unit 150, the debris reflecting surface 164a faces in the direction H1 normal to the irradiation position I. As a result, the debris D, which has belched out from the irradiation position I, collides with the debris reflecting surface 164a and is reflected by the debris reflecting surface 164a. Assuming that the direction in which the debris D is reflected by the debris reflecting surface 164a is a reflecting direction T, the reflecting direction T is a direction toward the inside of the cover 160 and is a direction different from the opening 166. Specifically, the reflecting direction can be controlled by the normal direction H2 of the debris reflecting surface 164a (see Fig. 4).

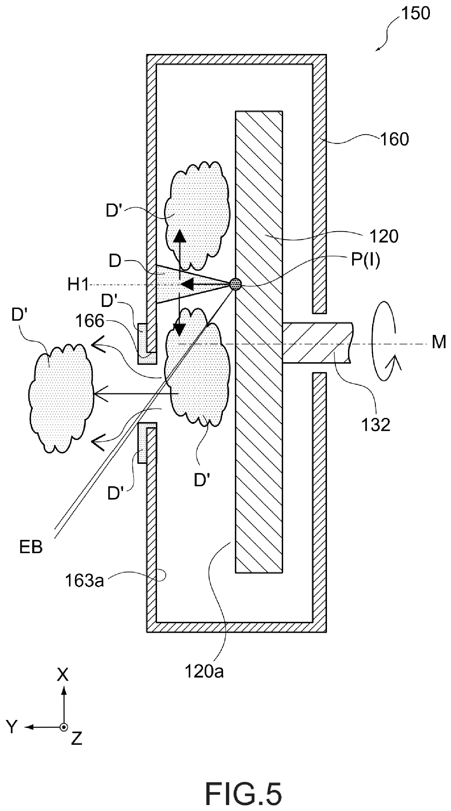

Fig. 5 is a schematic view showing an operation of the light source apparatus 100 when the debris reflecting structure 164 is not provided. As shown in the figure, when debris D belches out from the irradiation position I, the debris D collides with the facing surface 163a, thus generating debris D' containing various small particles. The debris D' diffuses within the cover 160, and part of the debris D' adheres to the opening 166. The debris D' that has adhered to the opening 166 narrows the opening 166 and blocks or attenuates the energy beam EB and radiation R passing through the opening 166, resulting in a decrease in output of the radiation R.

In addition, if the debris D' floats near the opening 166, the radiation R is absorbed by the debris D', which also causes a decrease in output of the radiation R. Additionally, if the debris D' is released from the opening 166, the debris D' may adhere to members inside the vacuum chamber 103 (see Fig. 1) and may cause malfunctions such as unwanted electrical conduction.

In contrast, when the debris reflecting surface 164a is provided as shown in Fig. 4, the debris D is reflected by the debris reflecting surface 164a in the reflecting direction T, which is a direction different from the opening 166, thereby preventing the debris D from adhering to the opening 166. This makes it possible to prevent the energy beam EB and the radiation R from being blocked or attenuated and prevent a decrease in output of the radiation R caused by the debris D. In addition, since the release of the debris D from the opening 166 is also suppressed, it is possible to prevent malfunctions in external members.

### [Regarding Incident Port and Emission Port]

As described above, the debris reflecting surface 164a reflects the debris incident from the irradiation position I in a direction different from the opening 166. Here, the opening 166 may include an incident port and an emission port. An incident port 167 is an opening provided to the flat plate portion 163, through which the energy beam EB passes. An emission port 168 is an opening provided to the flat plate portion 163, through which the radiation R passes. In this case, the debris reflecting surface 164a is configured such that a component H3 is directed in a direction different from the incident port 167 and emission port 168. In this case as well, the adhesion of debris D to the incident port 167 and emission port 168 as well as the release of debris D from the incident port 167 and emission port 168 can be suppressed. In addition, the debris reflecting surface 164a may be configured such that the component H3 is directed toward the emission port 168. In this case as well, since the debris D reflected by the debris reflecting surface 164a scatters at a shallower angle relative to the emission port 168 as compared with the case where the debris reflecting structure 164 is not provided (see Fig. 5), it is possible to suppress the adhesion of debris D to the incident port 167 and emission port 168 and the release of debris D from the incident port 167 and emission port 168.

### [Regarding Angle of Debris Reflecting Surface]

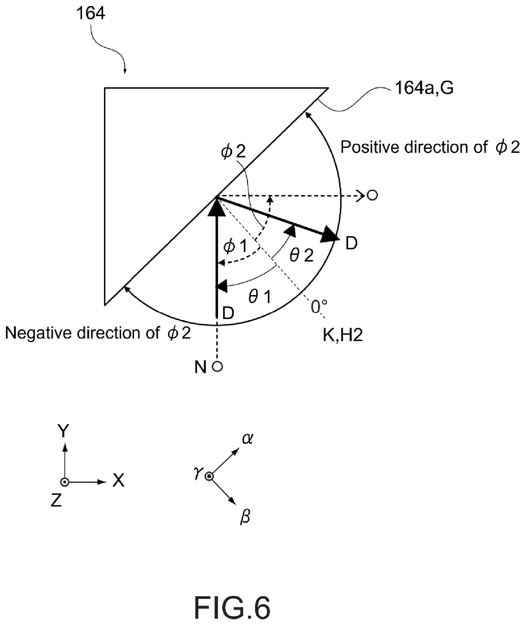

The angle of the debris reflecting surface 164a will be described. Fig. 6 is a schematic diagram showing an incident angle and a reflection angle of the debris D incident on the debris reflecting surface 164a. As shown in the figure, the angle of the debris D incident on the debris reflecting surface 164a to the normal direction H2 is represented as an incident angle θ1, and the angle of the debris D reflected on the debris reflecting surface 164a to the normal direction H2 is represented as an reflection angle θ2.

Here, the angle of the debris reflecting surface 164a and the reflection angle of the debris D were examined by simulation. Using binary collision simulation software TRIM (TRanspotation of Ion in Material), the Monte Carlo method using binary collision approximation was performed to obtain a recoil direction of ions N corresponding to an incident energy and a collision angle with respect to a collision surface G, as shown in Fig. 6. The direction normal to the collision surface G is represented as a normal direction K, the angle of ions N colliding with the collision surface G to the normal direction K as a collision angle φ1, and the angle of ions N recoiling on the collision surface G to the normal direction K as a recoil angle φ2. In this simulation, the behavior of ions N projected on the X-Y plane is focused on.

For example, if the collision angle φ1 is 45° and the recoil angle φ2 is -45°, ions N will return to the injection point. Since the ease of recoiling of ions N varies depending on the incident energy or collision angle of ions N, calculations were performed until the number of recoiling ions N reached a sufficient number of samples to investigate the angular distribution. For example, in the case of an incident energy of 5 keV and a collision angle φ1 of 45°, six million sample ions were caused to collide with the collision surface G, thus evaluating their recoil angles φ2.

Theoretically, the traveling direction of ions may change slightly between the ion injection point and the collision surface G. Therefore, the collision angle φ1 will not strictly match the specified numerical value. However, since debris is thought to be generated over a certain range in an actual light source apparatus, this does not pose a practical problem.

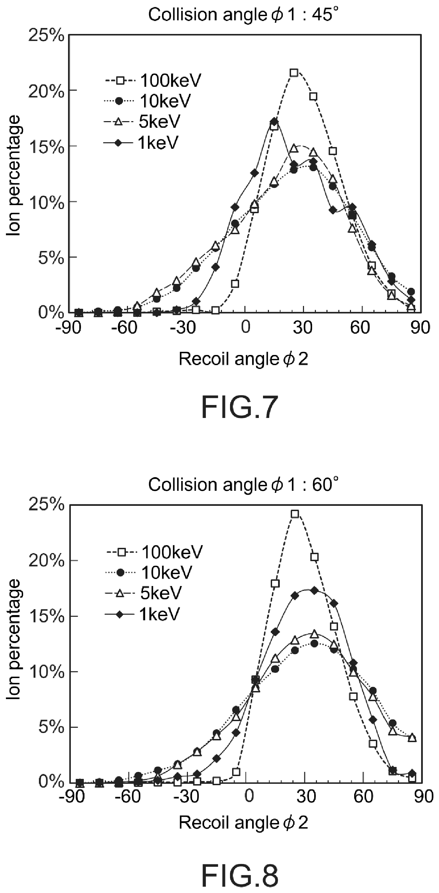

Fig. 7 is a graph showing a distribution of recoiling ions in each incident energy when the collision angle φ1 is 45°. Fig. 8 is a graph showing a distribution of recoiling ions in each incident energy when the collision angle φ1 is 60°.

As shown in those figures, when the incident energy is 1 keV, the recoil angle φ2 peaks at approximately 30° to 40°. The incident energy of 1 eV is the lowest energy under the conditions that have been examined. As the debris has a higher energy, the damage on the focusing mirror and the like upon collision becomes greater. However, it is believed that the proportion of low-energy debris within the total amount of debris is higher than that of debris at other energies examined in the simulation. Since the recoil angle φ2 peaks at approximately 30° to 40°, when the incident energy is 1 keV, the total amount of debris D incident at the irradiation position I in the debris D reflected by the debris reflecting surface 164a is obviously smaller than the total amount of debris D incident at the other positions.

When the incident energy is 100 keV, the recoil angle φ2 peaks at approximately 30° to 40° in all calculation results.

It is found from Figs. 7 and 8 that as the collision angle φ1 becomes larger, the recoil angle φ2 is more likely to cluster around a certain angle. In addition, in this model, as the angle of the collision surface G becomes steeper, the normal direction K moves away from the incident direction of the ions N. Therefore, it is shown that the reflection angle θ2 of the debris D can be controlled by changing the angle of the debris reflecting surface 164a relative to the incident direction of the debris D.

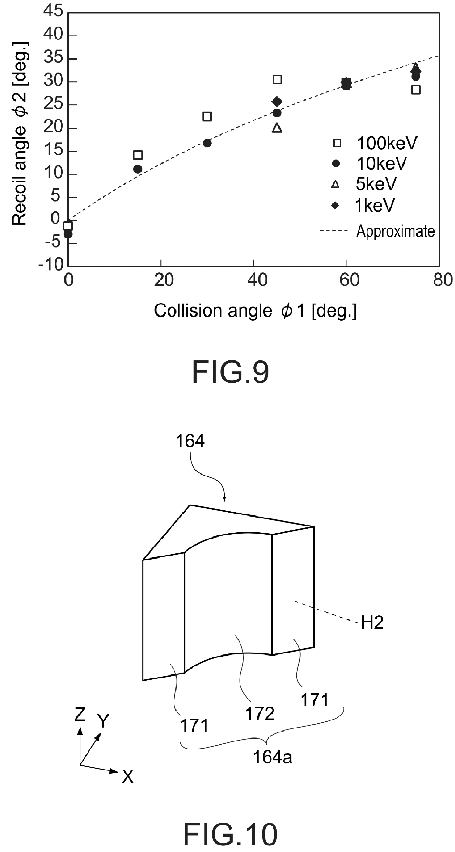

Fig. 9 is a graph plotting the average recoil angle against the collision angle φ1. The average recoil angle is the average value of the recoil angle φ2. As shown in the figure, it can be seen that, regardless of the ion energy, the recoil angle φ2 [degrees] is 40 Ln (0.018 φ1) with respect to the collision angle φ1 [degrees]. It should be noted that the peak near 90° of the recoil angle φ2 at an incident energy of 1 keV and a collision angle φ1 of 75° is excluded from this calculation.

As described above, the recoil angle φ2 and the total number of reflected ions N depend on the incident energy of the ions N and the collision angle φ1. In addition, since ions N tended to recoil more easily as the collision angle φ1 increased, it is effective to provide the debris reflecting surface 164a in order to prevent the debris D from returning to the irradiation position I as much as possible. Note that the variation in the recoil angle φ2 was approximately σ = 15 to 35°. There are several possible factors of this variation. For example, it appears to be related to the fact that the calculated collision angle φ1 does not strictly correspond to the specified value. Considering the variations in the collision angle φ1 and the recoil angle φ2, it is suitable to provide means of restricting the trajectory of debris D reflected by the debris reflecting surface 164a, as will be described later.

### [Various Configurations of Debris Reflecting Structure]

As described above, the debris reflecting structure 164 only needs to be configured such that the debris reflecting surface 164a reflects the debris incident from the irradiation position I in a direction different from the incident path of the energy beam EB to the irradiation position I, and thus can be configured to have various configurations. Figs. 10 to 12 are schematic views of the debris reflecting structures 164 having various configurations.

As shown in Fig. 10, the debris reflecting surface 164a may include flat surfaces 171 and a curved recess 172. As described above, the normal direction H2 of the debris reflecting surface 164a is a direction in which the component H3 (see Fig. 4) parallel to the rotation surface 120a (Z-X plane) is directed in a direction different from the opening 166.

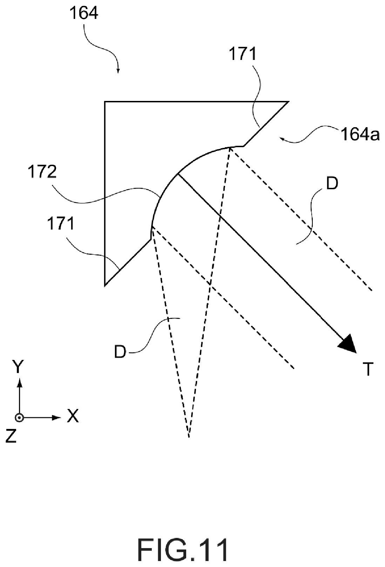

Fig. 11 is a schematic view showing the reflection of debris D by the debris reflecting surface 164a. As shown in the figure, the debris reflecting surface 164a is curved, so that the debris D can be reflected in a manner that concentrates the debris D in a single direction. When the irradiation position I is close to the debris reflecting surface 164a, it suffices that only a portion of the debris reflecting surface 164a is curved in this manner.

In addition, the debris reflecting surface 164a may have a shape including a flat surface and a hemispherical recess. In this case, the debris D can be reflected in a manner that concentrates the debris D in a single point. Additionally, the debris reflecting surface 164a may be formed of multiple small, curved surfaces combined together. In this case, it is not possible to concentrate the debris D in a single direction, but it is possible to suppress the divergence of the debris D. Further, the debris reflecting surface 164a can be configured as a stepped structure formed of multiple small planes combined together.

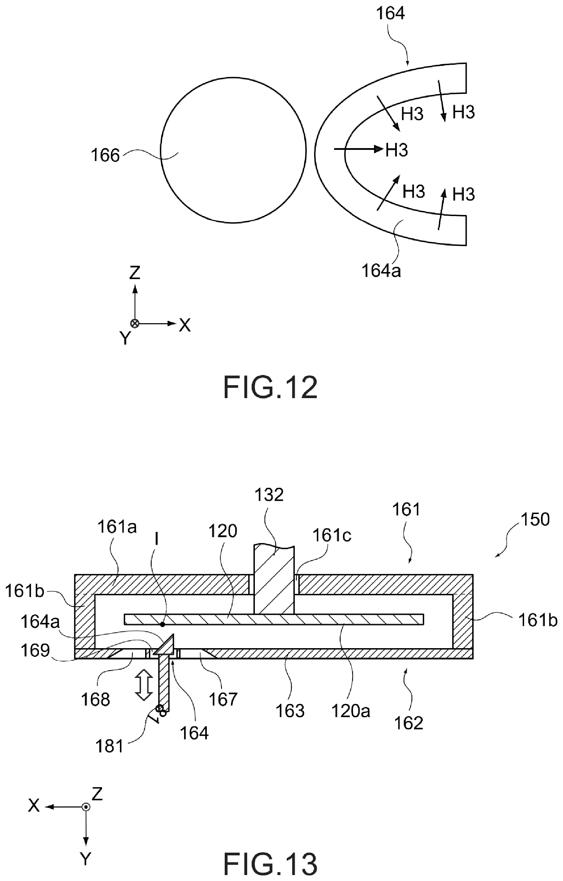

Further, as shown in Fig. 12, the debris reflecting surface 164a may have a C-shape as viewed from the normal direction H1 (Y direction). As shown in Fig. 12, in a suitable debris reflecting surface 164a, the component H3 located at each position is directed inside the C-shape and in a direction different from the opening 166. In addition, the debris reflecting surface 164a may include both a flat surface and a curved recess.

Further, the debris reflecting surface 164a may have a C-shape as viewed from the normal direction H1 (Y direction), and the component H3 located at each position may be directed outside the C-shape and in a direction different from the opening 166. In addition, a plurality of debris reflecting structures 164 may be provided, and a plurality of debris reflecting surfaces 164a may also be provided. In this case as well, the component H3 located at each position may be directed in a direction different from the opening 166.

A support structure of the debris reflecting structure 164 is not limited to being disposed on the flat plate portion 163 of the cover 160 as described above. Fig. 13 is a schematic view showing a support configuration of the debris reflecting structure 164. As shown in the figure, in the flat plate portion 163, an opening 169 is provided at a position facing the irradiation position I. The debris reflecting structure 164 is supported by a support member 181 different from the cover 160, and the debris reflecting surface 164a faces the irradiation position I via the opening 169. The support member 181 is not particularly limited, but may have, for example, a cantilever structure that connects the debris reflecting structure 164 to an external member such as the chamber body 109 (see Fig. 1). The support member 181 can be moved closer to or farther from the rotation body 120 as indicated by the arrows in the figure, thereby allowing the distance between the debris reflecting surface 164a and the rotation surface 120a to be adjusted.

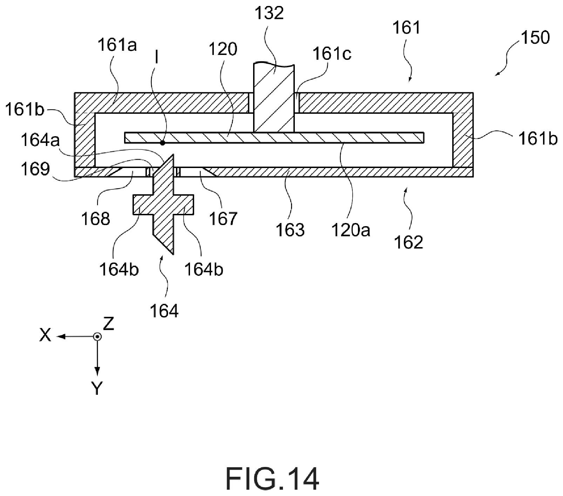

In addition, the debris reflecting structure 164 may be rotatable. Fig. 14 is a cross-sectional view of a rotation body unit 150 including a rotatable debris reflecting structure 164. As shown in the figure, the debris reflecting structure 164 includes a rotation shaft 164b and is configured to rotate about the rotation shaft 164b. The rotation shaft 164b is a shaft extending in a direction (X direction) perpendicular to the normal direction H1 (see Fig. 4). The debris reflecting surface 164a is a surface of the debris reflecting structure 164 that surrounds the rotation shaft 164b, and a portion thereof faces the irradiation position I via the opening 169. When the debris reflecting structure 164 rotates, the portion of the debris reflecting surface 164a that faces the irradiation position I is switched along with that rotation.

When debris D is incident on the debris reflecting surface 164a, the debris reflecting surface 164a is heated by the kinetic energy possessed by the debris D. Here, when the debris reflecting structure 164 is rotated, the debris reflecting surface 164a facing the irradiation position I can be switched, thereby extending the service life of the debris reflecting structure 164.

In addition, in the rotatable debris reflecting structure 164 as well, the debris reflecting surface 164a can be formed into a curved shape. Additionally, the debris reflecting structure 164 may be configured to be rotatable, and the debris reflecting surface 164a may be configured to have various shapes as described above.

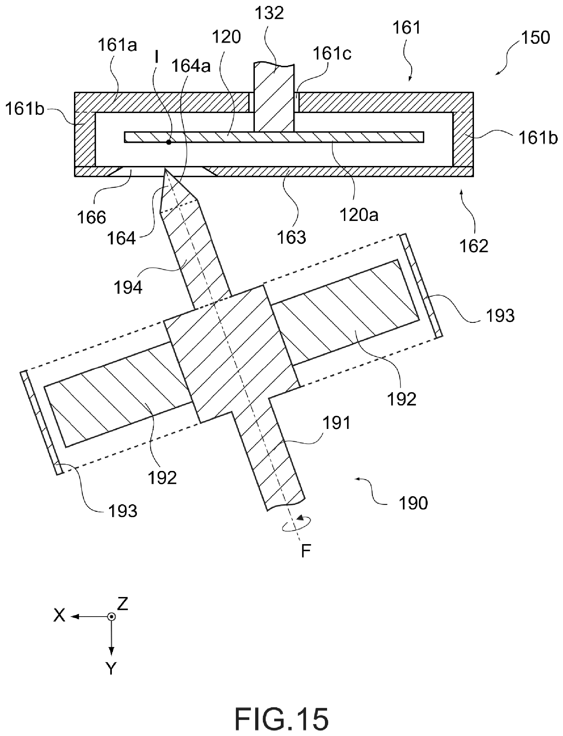

A rotary foil trap may also be used to rotate the debris reflecting structure 164. Fig. 15 is a cross-sectional view of a rotation body unit 150 including a rotary foil trap 190. As shown in the figure, the rotary foil trap 190 includes a central support post 191, a foil 192, and an outer circumferential ring 193.

The central support post 191 is connected to a rotational drive source (not shown) and rotates about a rotation axis F. The foil 192 is connected to the central support post 191 and has a plate shape parallel to the traveling direction of the radiation R released from the irradiation position I. A plurality of foils 192 are provided radially as viewed from the direction of the rotation axis F. The outer circumferential ring 193 is an annular member centered on the rotation axis F and surrounds the circumference of the foil 192. In the rotary foil trap 190, as the foil 192 rotates about the rotation axis F, debris that has passed through the opening 166 collides with the foil 192 and is captured by the foil 192.

The debris reflecting structure 164 is connected to the rotary foil trap 190 and rotates in conjunction with the rotation of the rotary foil trap 190. Specifically, the debris reflecting structure 164 is disposed on the rotation axis F and is supported by a support member 194 fixed to the central support post 191. As the central support post 191 rotates, the debris reflecting structure 164 rotates about the rotation axis F. The debris reflecting structure 164 has a shape such as a conical shape centered on the rotation axis F. With this structure, the debris reflecting structure 164 can also be rotated by the rotational drive source for the rotary foil trap 190, thus eliminating the need to provide a separate rotational drive source for the debris reflecting structure 164.

Further, in the configuration in which the debris reflecting structure 164 is rotated by utilizing the rotation of the rotary foil trap 190, the debris reflecting structure 164 may be supported by a support member, and the support member may be connected to the central support post 191 via a rotation transmitting mechanism. The rotation transmitting mechanism is a mechanism that transmits the rotation of the central support post 191 to the support member, and is formed of gears or the like.

Accordingly, when the central support post 191 rotates about the rotation axis, that rotation is transmitted to the support member via the rotation transmitting mechanism, and the support member and the debris reflecting structure 164 rotate about the rotation axis. Use of the rotation transmitting mechanism makes it possible to rotate the debris reflecting structure 164 by the rotational drive source for the rotary foil trap 190, even if the debris reflecting structure 164 is disposed away from the rotation axis of the rotary foil trap 190. The debris reflecting structure 164 has, for example, a conical shape centered on the rotation axis.

The rotary foil trap 190 and the configuration that rotates the debris reflecting structure 164 by the rotation of the rotary foil trap 190 are not limited to those described above, and any configuration may be used as long as the debris reflecting structure 164 can be rotated by the rotation of the rotary foil trap 190.

### [Regarding Present Disclosure]

At least two of the feature parts according to the present technology described above can be combined. In addition, the various effects described above are merely illustrative and are not limitative, and other effects may also be exerted.

### Reference Signs List

- 100: light source apparatus
- 101: plasma raw material
- 106: plasma generation mechanism
- 108: beam source
- 120: rotation body
- 131: rotational drive source
- 132: shaft portion
- 133: reservoir
- 134: film thickness adjustment mechanism
- 150: rotation body unit
- 160: cover
- 161: first cover member
- 162: second cover member
- 164: debris reflecting structure
- 164a: debris reflecting surface
- 164b: rotation shaft
- 166: opening
- 167: incident port
- 168: emission port
- 169: opening
- 190: rotary foil trap

## Claims

1. A plasma generation mechanism included in a light source apparatus that converts a liquid plasma raw material into plasma by irradiation of an energy beam and extracts radiation, the plasma generation mechanism comprising:
a rotation body having a rotation surface, the rotation surface being a surface that rotates about a rotation axis;
a rotational drive source that rotates the rotation body about the rotation axis;
a raw material supply section that supplies the plasma raw material to the rotation body; and
a debris reflecting surface that faces in a direction normal to an irradiation position that is irradiated with the energy beam, and reflects debris incident from the irradiation position in a direction different from an incident path of the energy beam to the irradiation position.

2. The plasma generation mechanism according to claim 1, wherein
the irradiation position is located on the rotation surface.

3. The plasma generation mechanism according to claim 1, wherein
the debris reflecting surface reflects the debris incident from the irradiation position in a direction different from the incident path of the energy beam to the irradiation position and an emission path of the radiation from the irradiation position.

4. The plasma generation mechanism according to claim 1, wherein
the raw material supply section includes a reservoir that stores the plasma raw material, and
part of the rotation surface of the rotation body is immersed in the plasma raw material stored in the reservoir.

5. The plasma generation mechanism according to claim 4, further comprising
a cover that forms the reservoir and surrounds the rotation body, wherein
a direction normal to the debris reflecting surface at each position of the debris reflecting surface faces inside the cover.

6. The plasma generation mechanism according to claim 5, wherein
the cover includes an opening through which the energy beam passes, and
the debris reflecting surface reflects the debris incident from the irradiation position in a direction different from the opening.

7. The plasma generation mechanism according to claim 6, wherein
the opening includes an incident port through which the energy beam passes, and an emission port through which the radiation passes, and
the debris reflecting surface faces the irradiation position via the opening.

8. The plasma generation mechanism according to claim 5, wherein
the cover includes a facing surface that faces the rotation surface, and
the debris reflecting surface is a surface of a debris reflecting structure provided on the facing surface at a position facing the irradiation position.

9. The plasma generation mechanism according to claim 7, wherein
the debris reflecting surface is a surface of a debris reflecting structure supported by a support member different from the cover.

10. The plasma generation mechanism according to claim 1, wherein
the debris reflecting surface is at least partially curved.

11. The plasma generation mechanism according to claim 1, wherein
the debris reflecting surface is a surface of a rotatable debris reflecting structure.

12. The plasma generation mechanism according to claim 1, wherein
the radiation is extreme ultraviolet light or X-rays.

13. The plasma generation mechanism according to claim 1, wherein
the plasma raw material is tin, lithium, gadolinium, terbium, gallium, bismuth, indium, or an alloy including at least one of these materials.

14. A light source apparatus that converts a liquid plasma raw material into plasma by irradiation of an energy beam and extracts radiation, the light source apparatus comprising:
a plasma generation mechanism including
a rotation body having a rotation surface, the rotation surface being a surface that rotates about a rotation axis,
a rotational drive source that rotates the rotation body about the rotation axis,
a raw material supply section that supplies the plasma raw material to the rotation body, and
a debris reflecting surface that faces in a direction normal to an irradiation position that is irradiated with the energy beam, and reflects debris incident from the irradiation position in a direction different from an incident path of the energy beam to the irradiation position; and
a beam source that causes the energy beam to be incident at the irradiation position.
